Europäisches Patentamt

European Patent Office

Office européen des brevets

(19)

(11) Publication number: **0 272 479**
**A2**

# EUROPEAN PATENT APPLICATION

(21) Application number: 87117327.4

(22) Date of filing: 24.11.87

(51) Int. Cl.4 **H03K 5/24** , H03K 3/288 , G01R 19/165

(30) Priority: 22.12.86 US 944650

(43) Date of publication of application:
29.06.88 Bulletin 88/26

(84) Designated Contracting States:
**DE FR GB NL**

(71) Applicant: **TEKTRONIX, INC.**
**Howard Vollum Park 14150 S.W. Karl Braun**
**Drive P.O. Box 500**
**Beaverton Oregon 97077(US)**

(72) Inventor: **Valdis, E. Garuts**
**14170 S. W. 22nd Street**
**Beaverton Oregon 97005(US)**

(74) Representative: **Liska, Horst, Dr. et al**
**Patentanwälte H. Weickmann, Dr. K. Fincke,**
**F.A. Weickmann, B. Huber, Dr. H. Liska, Dr. J.**
**Prechtel Möhlstrasse 22 Postfach 86 08 20**
**D-8000 München 86(DE)**

(54) **Differential comparator with reduced delay variation.**

(57) A differential comparator includes a matched pair of transistors having emitters coupled to a current source through a pair of emitter-degeneration resistors and having collectors coupled to a voltage source through a pair of load resistors such that a differential input voltage applied across the transistor bases produces an amplified differential output voltage across the transistor collectors. The emitter-degeneration resistors are sized so that a differential input current produced in the bases of the amplifier transistors is substantially constant over a range of differential input voltage including the range for which the amplifier transistors remain active when the input voltage varies with constant slew rate, thereby minimizing variation in input capacitance with respect to input voltage. This in turn minimizes variation in time delay between the comparator differential input and output voltages with respect to input voltage slew rate.

FIG. I

EP 0 272 479 A2

# DIFFERENTIAL COMPARATOR WITH REDUCED DELAY VARIATION

## Background of the Invention

The present invention relates in general to differential comparators and in particular to a differential comparator circuit which minimizes delay distortion of input signals having variable slew rates.

A strobed comparator circuit of the prior art includes a comparator stage for amplifying the difference between an input signal and a reference signal, and having a strobed latch stage for generating a latched output signal when strobed by a strobe signal, the state of the latched output signal indicating whether the input signal magnitude exceeds the reference signal. However, the output signal of such a strobed comparator circuit is "delayed" in that it does not represent the result of a comparison between the input and reference signals at the moment the strobe signal is asserted but rather represents a comparison made at some time prior to assertion of the strobe signal. The delay is due to the time required for differential circuits in the comparator and latch stages to respond to a change in the input signal or the reference signal.

In a typical differential comparator of the prior art, signal delay is affected by comparator input capacitance and signal source resistance. The capacitance is inherent in transistors forming the difference comparator. The resistance includes the resistance of the signal source, if any, plus the inherent base resistance of the transistors forming the differential comparator. The resistance and capacitance form a low pass filter which determines a substantial part of the signal delay through the comparator. Since the capacitance varies with the input voltage, the amount of signal delay through a differential comparator varies with the shape and slew rate of the input waveform and causes "signal delay distortion" in the comparator output wherein slowly changing portions of an input waveform are delayed by differing amounts of time than fast changing portions of the input waveform. Thus, for example, when the differential comparator input signal is a sine wave, the comparator output signal is distorted wherein signal peaks are skewed to one side.

A bank of strobed comparator circuits using reference signals of differing magnitudes is often employed to digitize a waveform by periodically comparing the waveform to the reference signals to produce a sequence of "thermometer code" data values formed by parallel outputs of the strobed comparator circuits. Each data value of the sequence (thermometer code) expresses a magnitude of the waveform at a particular time by indicating which reference signal magnitudes are higher and which are lower than the waveform magnitude. The thermometer code data sequence is typically converted into a binary code sequence representing the waveform magnitude at successive strobe times. Digital oscilloscopes utilize such data sequences to produce a graphical image of the waveform on a screen. But signal delay distortion in the strobed comparator circuits is reflected in the data sequence and the resulting image representing the waveform is therefore distorted. Such distortion is most pronounced for high frequency input signals in which input signal slew rate varies over a wide range during each cycle of the input signal.

Strobed sample and hold circuits are sometimes utilized to convert an input waveform to a series of fixed DC levels prior to application to a strobed comparator circuit so that the slew rate of the input signal is a constant value (zero). This insures that the delay through each differential comparator in the comparator bank is the same irrespective of the slew rate of the input signal to the sample and hold circuit, thereby reducing delay distortion. However, sample and hold circuits add complexity and expense to the system and it would be useful to provide a differential comparator having minimal output signal delay variation with respect to the slew rate of an input signal so that sample and hold preconditioning of an input waveform is not necessary in order to minimize delay distortion.

## Summary of the Invention

A differential comparator includes a matched pair of transistors having emitters coupled to a current source through a pair of emitter-degeneration resistors and having collectors coupled to a voltage source through a pair of load resistors such that a differential input signal applied across the transistor bases produces an amplified differential output voltage across the transistor collectors. In accordance with one aspect of the present invention, the emitter-degeneration resistors are sized so that an input current produced in the bases of the transistor pair is substantially constant with respect to a differential input signal voltage varying with constant slew rate over a range including the range for which the comparator transistors are both active. Since the input current of the comparator is substantially constant, when the input voltage varies with constant slew rate, the input admittance of

3  0 272 479  4

the comparator is a substantially constant capacitance which remains constant despite changes in the differential input voltage. Therefore when the values of the emitter-degeneration resistors are sized in this fashion, a low pass filter formed by the signal source resistance and the input capacitance is substantially independent of the input signal, and the variation in delay between a change in the comparator differential input voltage and a resulting change in comparator differential output voltage with input signal shape and slew rate is minimized.

In accordance with another aspect of the invention, signal delay variation with respect to differential input voltage slew rate is further minimized by limiting the range of the differential input voltage so as to insure that both transistors remain in a region wherein the adjustment of the emitter-degeneration resistors most effectively reduces dependence of comparator input capacitance on differential input signal voltage.

It is accordingly an object of the invention to provide an improved differential comparator wherein signal delay is substantially constant with respect to differential input signal shape and slew rate.

The subject matter of the present invention is particularly pointed out and distinctly claimed in the concluding portion of this specification. However, both organization and method of operation of the present invention, together with further advantages and objects thereof, may best be under stood by reference to the following description taken in connection with accompanying drawings wherein like reference characters refer to like elements.

## Drawings

FIG. 1 is a schematic diagram of a strobed comparator circuit utilizing differential comparators according to the present invention;

FIG. 2 is a schematic diagram of a differential comparator of the strobed comparator circuit of FIG. 1 utilizing Gummel-Poon models including the essential non-linear elements to represent transistors within the differential comparator;

FIG. 3 is a graphical representation of the time dependent behavior of currents and voltages associated with the differential comparator of the circuit of Fig. 2 when the emitter-degeneration resistors of the comparator have zero resistance; and

FIG. 4 is a graphical representation of the time dependent behavior of voltages and currents associated with the differential comparator of the circuit of FIG. 2 when the emitter-degeneration resistors of the comparator have been adjusted according to the present invention.

## Detailed Description

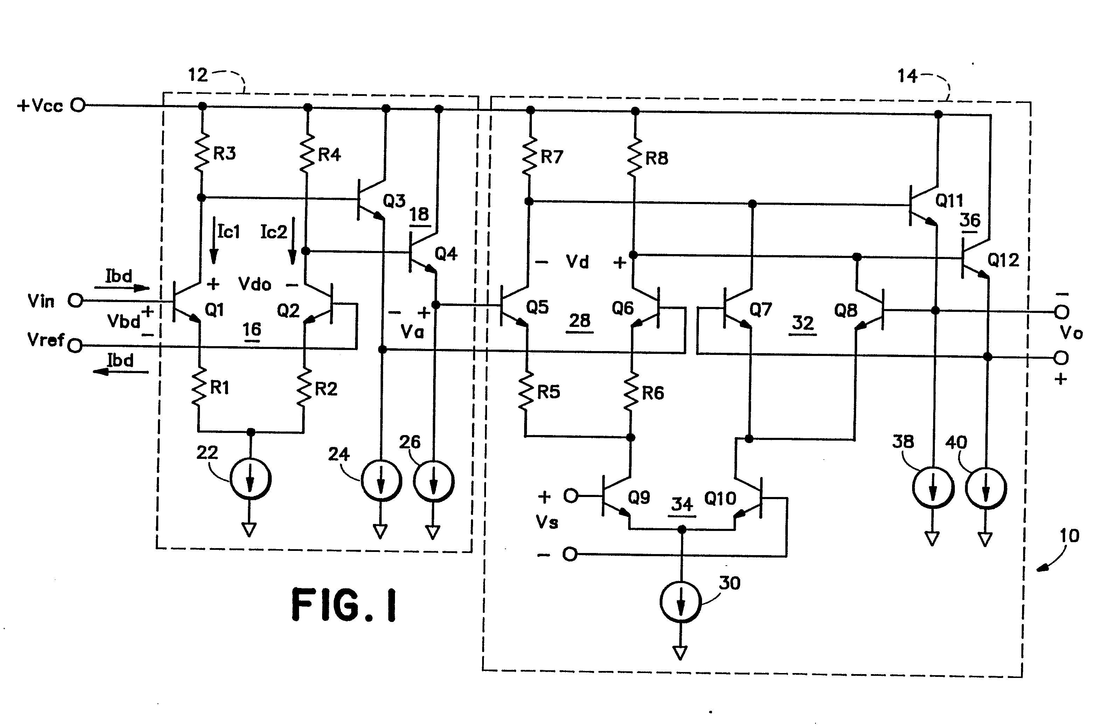

FIG. 1 depicts in schematic diagram form a strobed comparator 10 adapted to produce a differential comparator output signal Vo of state indicating whether the magnitude of an input signal Vin is greater than or less than a reference signal Vref in response to a differential strobe signal Vs. The strobed comparator 10 includes a first comparator stage 12 which amplifies the difference between Vin and Vref to produce an amplified, differential output voltage Va, and a strobed latch stage 14 which latches the comparator 10 output signal Vo to a high or low logic level state on an edge of the strobe signal Vs to indicate the (positive or negative) sense of the comparator stage 12 output voltage Va.

The first comparator stage 12 includes a differential comparator 16 comprising a pair of NPN transistors Q1 and Q2 having emitters connected to a current source 22 through a pair of emitter-degeneration resistors R1 and R2, respectively, and having collectors connected to a source of positive voltage Vcc through a pair of load resistors R3 and R4, respectively. Vin is applied to the base of transistor Q1 and Vref is applied to the base of transistor Q2. Under steady state conditions (when the potential difference between the input signal Vin and reference signal Vref is constant), the differential comparator 16 output voltage Vdo between the collectors of transistors Q2 and Q1 is substantially proportional to the base-to-base differential input voltage Vbd across the bases of transistors Q1 and Q2, provided Vbd is within a range for which transistors Q1 and Q2 both operate in their active regions.

The differential comparator 16 output voltage Vdo is buffered by an emitter-follower amplifier 18 comprising a pair of npn transistors Q3 and Q4 and a pair of current sources 24 and 26 respectively connected between the emitters of transistors Q3 and Q4 and ground. The collector of transistor Q1 is connected to the base of transistor Q3, the collector of transistor Q2 is connected to the base of transistor Q4, and the collectors of both transistors Q3 and Q4 are connected to voltage source Vcc. The output voltage Va of comparator state 12 appears across the emitters of transistors Q4 and Q3 and follows the differential comparator 15 output voltage Vdo applied across the bases of transistors Q4 and Q3.

The latch stage 14 of the strobed comparator 10 includes an input differential comparator 28 comprising npn transistors Q5 and Q6 having collectors connected to voltage source Vcc through load resistors R7 and R8, respectively, and having emitters coupled to the collector of an npn transistor Q9 through emitter-degeneration resistors R5

3

and R6, respectively. The emitter of transistor Q9 is coupled to ground through a current source 30. The latch stage 14 also includes a feedback differential amplifier 32 comprising npn transistors Q7 and Q8 having collectors coupled to the collectors of transistors Q5 and Q6, respectively, and having emitters connected to the collector of an npn transistor Q10. The emitter of transistor Q10 is also coupled to ground through current source 30. The strobe signal Vs is applied across the bases of transistors Q9 and Q10 which form a switch 34 for switching current drawn by current source 30 between the emitters of transistors Q5 and Q6 of the input differential comparator 28 and the emitters of transistors Q7 and Q8 of the feedback differential amplifier 32.

When the strobe signal Vs is positive (i.e., when the base of transistor Q9 is driven high and the base of transistor Q10 is driven low), transistor Q9 is on and transistor Q10 is off. The current source 30 draws current from the emitters of transistors Q5 and Q6 via transistors R5 and R6 and the collector-emitter path of transistor Q9, rather than from the emitters of transistors Q7 and Q8 via the collector-emitter path of transistor Q10. The difference voltage output Va of the comparator stage 12 is applied across the bases of transistors Q5 and Q6 and a voltage Vd produced across the collectors of transistors Q6 and Q5 is proportional to VA under steady state conditions (i.e., when Va is constant and not varying) over a range of Va magnitude for which transistors Q5 and Q6 operate in their active regions.

This output voltage Vd of comparator 28 is buffered by an emitter-follower amplifier 36 comprising npn transistors Q11 and Q12 and a pair of current sources 38 and 40 respectively coupling the emitters of transistors Q11 and Q12 to ground. The Vd voltage is applied across the bases of transistors Q12 and Q11 and the Vcc voltage source is connected to the collectors of the two transistors. The output signal Vo of the strobed comparator 10 is produced across the emitters of transistors Q12 and Q11 and follows Vd. Output signal Vo is fed back across the bases of transistors Q7 and Q8 of the feedback differential amplifier 32.

As previously mentioned, when the strobe signal Vs is positive, switch 34 connects current source 30 to the emitters of the transistors of the latch input differential comparator 28 and comparator 28 controls voltage Vd according to the difference voltage output Va of comparator stage 12. When Vs is subsequently reversed in polarity (driven negative), transistor Q10 turns on and transistor Q9 turns off such that switch 34 diverts current of current source 30 away from input differential comparator 28 and permits current source 30 to draw current from the emitters of transistors Q7 and Q8 of the feedback amplifier 32, thereby turning off comparator 28 and turning on amplifier 32. At this point the voltage Vd is controlled by feedback amplifier 32 rather than by input comparator 28. Emitter-follower amplifer transistors Q11 and Q12 provide positive feedback to feedback amplifier 32 such that when Vd and Vo are initially positive at the moment strobe signal Vs is driven negative, transistor Q8 quickly turns off and transistor Q7 conducts all of the current from transistor Q10 so that Vo is driven to a positive logic level. Conversely, when Vd and Vo are initially negative at the moment strobe signal Vs is driven negative, transistor Q7 turns off and transistor Q8 conducts all of the current from transistor Q10 so as to drive Vo to a negative logic level. The Vo output signal remains at its positive or negative logic level until the polarity of the strobe signal Vs is switched again to postive. At that time comparator 28 resumes control of Vd and sets Vd according to the magnitude of Va.

Thus it is seen that when the differential input voltage Vbd is constant and the strobe signal Vs is positive, the (positive or negative) sense of output voltage Vd of the comparator 28 indicates whether or not Vin exceeds Vref. It is also seen that when the strobe signal Vs is subsequently driven negative, positive feedback through amplifier 32 drives the output Vo to a high or low logic level depending on whether Vd was positive or negative at the moment Vs was driven negative. However, when the differential input voltage Vbd is not constant but is changing, the magnitude of Vd at the moment the strobe signal is driven negative is proportional to the magnitude of Vbd at some earlier time. When comparator 28 controls Vd, there is a delay between a change to the differential input voltage Vbd and a corresponding change in Vd, the delay being due primarily to delays in the responses of differential comparators 16 and 28 to changes in their differential input voltages, Vbd and Va.

With reference to comparator 16, inherent device capacitance between the bases and emitters of transistors Q1 and Q2 must be charged or discharged by a differential input current Ibd supplied through the base resistances of these transistors during a change in differential input voltage Vbd. The charging and discharging of these capacitances in part delays the effects on the differential comparator 16 output voltage Vdo due to the change in differential input voltage Vbd. If the delay were constant regardless of the slew rate of Vbd, the differential output voltage Vdo would look like a delayed, amplified version of the differential input voltage Vbd and would not be distorted. However when the delay is not constant with respect to the slew rate of Vbd, the output voltage Vdo resulting from a differential input voltage Vbd having a variable slew rate (for example, a sine wave) would be distorted because a low slew rate input signal peak is delayed by a differing amount of time than a rapidly rising or falling portion of the input signal. Such delay distortion is particularly noticeable when the input signal is high frequency, having a slew rate which varies over a wide range during each cycle of the input signal.

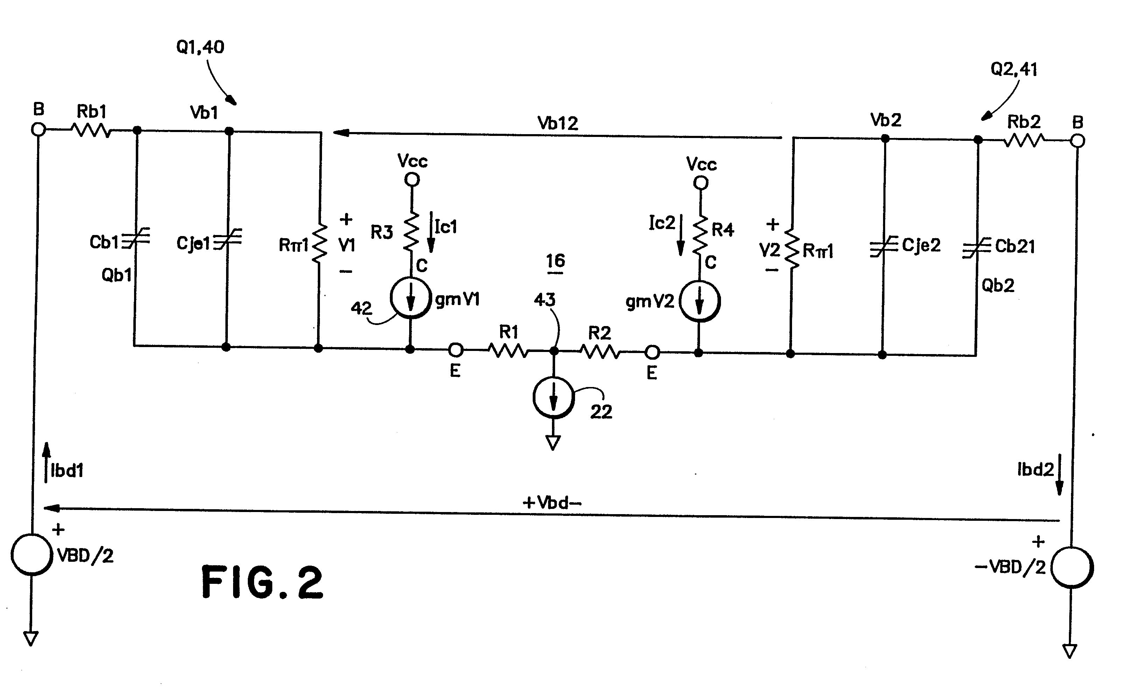

Referring to FIG. 2, differential comparator 16 of FIG. 1, including transistors Q1 and Q2, resistors R1-R4 and current source 22, is shown in - schematic diagram form with transistors Q1 and Q2 being represented by Gummel-Poon junction transistor models 40 and 41. The model 40 of transistor Q1 includes a variable capacitor Cb1 representing the base diffusion capacitance of transistor Q1, a variable capacitor Cje1 representing the emitter-base depletion layer capacitance of the transistor, and a pair of resistors Rb1 and $R_{\pi}1$ representing resistances between the base input terminal and the transistor base and between the transistor base and the emitter input terminal. Capacitors Cb1 and Cje1 and resistor $R_{\pi}1$ are connected in parallel and the parallel combination of Cb1, Cje1, and $R_{\pi}1$ is connected in series with Rb1 between the base B and emitter E of the transistor. The model 40 of Q1 also includes a current source $g_mV1$ connected between the collector C and the emitter of the transistor providing the collector current Ic1. The magnitude of the collector current Ic1 is proportional to the internal base voltage V1 across $R_{\pi}1$, the constant of proportionality between V1 and Ic1 being defined as the transconductance $g_m$ of the transistor Q1.

Transistor model 41 of transistor Q2 is similar to model 40 except that the last character in the reference labels for the capacitances, resistances, voltages and currents associated with transsistor Q2 is a "2" instead of a "1" as for transistor Q1. The emitters of models 40 and 41 of transistors Q1 and Q2 are connected through the series combination of emitter-degeneration resistors R1 and R2 and the node 43 connecting R1 and R2 is coupled to ground through current source 22. The collectors of models 40 and 41 are coupled to Vcc through load resistors R3 and R4. It should be appreciated that transistor models 40 and 41 are highly simplified and more accurate models including additional capacitances and resistances have been developed. However the simplified models are sufficient to explain phenomena relevant to the present invention.

For transistor Q1, the base charge Qb1 is proportional to the collector current Ic1 according to the expression:
Qb1 = $t_F$Ic1.
The parameter $t_F$, the base transit time for the base-emitter junction in the forward direction. is defined as the ratio of the minority carrier charge Qb1 in the base to the collector current Ic1. The base charge Qb2 is a similar function of the collector current Ic2 of transistor Q2.

The value of Cje1 is a function of the internal base voltage V1 of transistor Q1. When V1 is below the "built-in potential" of the base-emitter junction of transistor Q1 (the potential of the junction for zero applied bias), the emitter-base depletion layer capacitance Cje1 is a fractional power law function of internal base voltage V1, increasing slowly with V1 when V1 is negative or small and increasing more rapidly as V1 grows larger. The capacitance of Cje2 is a similar function of the internal base voltage V2 of transistor Q2.

The simplified Gummel-Poon model of comparator 16 of FIG. 2 is most useful for describing the behavior of the comparator when transistors Q1 and Q2 are operating in their active and off regions. Current source 22 requires that the sum of Ic1 and Ic2 be a constant. When Vbd is held at 0, the symmetry of comparator 16 suggests that Ic1 and Ic2 are each equal to one half of the current drawn by current source 22 and that the differential output current of the comparator (Ic1-Ic2) is zero. Since Ic1 and Ic2 are both nonzero, V1 and V2 are both sufficiently positive to ensure current sources $g_mV1$ and $g_mV2$ conduct the necessary collector currents. When Vbd is positive, V1 is increased, V2 is decreased and Ic1 is larger than Ic2. When Vbd is negative, V2 is larger than V1 and therefore Ic2 is larger than Ic1.

When Vbd is increased or decreased, changing the magnitudes of V1 and V2, capacitors Cb1, Cb2, Cje1, and Cje2 are charged or discharged. For instance when Vbd is increased, charge is supplied to Cb1 and Cje1 and removed from capacitor Cb2 and Cje2. Assuming, for example, that the emitter-degeneration resistors R1 and R2 have zero resistance, the currents Ibd1 and Ibd2 into the base of the model transistor 40 and out of the base of model transistor 41 are
Ibd1 = dQb1/dt + Cje1(dV1/dt) + V1/$R_{\pi}1$
Ibd2 = Cb2(-dV2/dt) + Cje2(-dV2/dt) + V2/$R_{\pi}2$ -dQb2/dt

When Q1 and Q2 are both active and Vbd is changing rapidly, terms containing dV/dt and dQ/dt are relatively large and terms containing V1 and V2 are relatively small. Neglecting these small terms of the above expressions, the base currents Ibd1 and Ibd2 for a rapidly slewing differential input coltage Vbd are approximated by the expressions
Ibd1 = dQb1/dt + Cje1(dV1/dt)
Ibd2 = -dQb2/dt + Cje2(-dV2/dt).
The signal which is actually amplified by transistors Q1 and Q2 is the differential voltage Vb12 across the intrinsic bases of the two transistors.

This signal differs from the external signal Vbd because of the voltage drops across Rb1 and Rb2 caused by currents Ibd1 and Ibd2 respectively, and is:

$$Vb12 = (Vb1 - Vb2) = Vbd - Rb1Ibd1 - Rb2Ibd2$$

For a symmetric amplifier, the base resistances are equal (Rb1 = Rb2 = Rb) and therefore,

$$Vb12 = Vbd - Rb(Ibd1 + Ibd2).$$

The second term on the right-hand side of the above expression is the "error voltage" due to the base currents. Since Rb is substantially constant the error is represented within a constant factor by a differential base current Ibd, defined as:

$$Ibd = Ibd1 + Ibd2$$
$$= Ib1 + Ije1 + Ib2 + Ije2$$

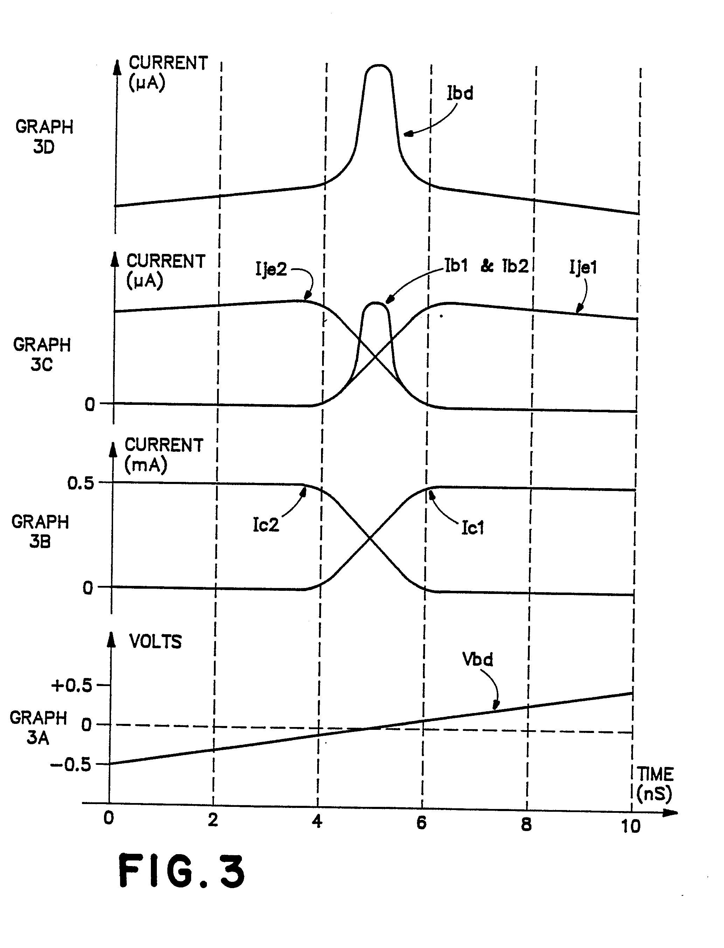

FIG. 3 is a graphical representation of the time dependent behavior of base currents associated with the differential comparator 16 of FIG. 2 in response to a steadily increasing differential input voltage Vbd when the emitter-degeneration resistors R1 and R2 have zero resistance. In a first graph 3A of FIG. 3, the differential input voltage Vbd, in this case a ramp rising linearly from -0.5 volts to +0.5 volts in 10 nS, is plotted as a function of time. In a second graph 3B of FIG. 3, the collector currents Ic1 and Ic2 produced in response to the differential input voltage Vbd are plotted as functions of time.

When Vbd is between -0.5V and -0.2V, transistor Q2 conducts the entire bias current 22, and its internal base to emitter voltage Vb2 is substantially constant. Transistor Q1 is nonconducting, and the voltage across Cje1 is substantially a linear ramp, being the difference between the linear ramp voltage Vbd and the constant Vb2.

Between Vbd of -0.2V and 0.2V, conduction of the bias current 22 is transferred from Q2 to Q1 in accordance with the well known hyperbolic secant law of bipolar transistor circuit theory. This is illustrated by the collector current curves in FIG. 3B. At Vbd near -0.2V, Q1 begins to conduct part of the bias current 22 as its base to emitter voltage increases, and the current in Q2 decreases by a like amount. Voltage Vb2 begins to decrease, and the rate of change of voltage across Cje1 decreases. At Vbd = 0V, Q1 and Q2 each conduct half of the bias current 22, voltages Vb1 and Vb2 are equal, and the rate of change of voltage across Cje1 and Cje2 are equal, each being half the rate of change of Vbd. For Vbd between 0.2V and 0.5V, Q1 conducts the entire bias current 22, and its base to emitter voltage Vb1 is constant. Transistor Q2 is nonconducting, and the voltage across Cje2 is substantially a linear ramp, being the difference between the linear ramp voltage Vbd and the constant Vb1.

In the third graph 3C of FIG. 3, the components Ib1, Ije1, Ib2 and Ije2 of the differential base current Ibd are plotted as functions of time. Strictly speaking, these curves are accurate for the case where the internal base voltage difference Vb12 is a linear ramp function of time, and are only approximate when Vbd is a linear ramp. For expositional simplicity it is assumed that Vb12 is a linear ramp; this assumption will not significantly affect the conclusions.

As stated earlier, the current Ije1 is equal to Cje1˚dV1 dt. Considering the previously described variations of V1 with Vb12, and of Cje1 with V1, the current Ije1 is as shown. Similar considerations apply to Ije2. Both currents are proportional to the rate of change of Vb12. As also stated previously, the base charges of Q1 and Q2 are proportional to the respective collector currents; therefore the base currents Ib1 and Ib2 are proportional to the time rate of change of said collector currents, which are the slopes of the collector current curves in graph 3B of FIG. 3. Since the sum of Ic1 and Ic2 is constant, the slopes are equal, and are superimposed on each other in graph 3C of FIG.3. Since the collector currents change simultaneously with Vb12, their rates of change are proportional to the rate of change of Vb12, and therefore Ib1 and Ib2 are also proportional to the rate of change of Vb12. Hence, the total differential base current is also proportional to the rate of change of Vb12. A symbolic expression for Ibd is:

$$Ibd = Cn(Vb12) \, ^* \, (dVb12/dt)$$

where the function Cn() describes the nonlinear dependence of Ibd on Vb12 normalized to unity rate of change of Vb12, and multiplication by the actual rate if change dV12b/dt gives the actual value of Ibd. Cn has the dimensions of capacitance.

Graph 3D of FIG. 3 is a plot of the differential input current Ibd versus time, current Ibd being the sum of components Ib1, Ib2, Ije1, and Ije2 of graph 3C. Note that in response to a differential base voltage Vbd rising with constant slew rate, the differential base current Ibd rises slowly with Vbd until both transistors Q1 and Q2 enter their active regions. In the active regions, the input current Ibd sharply increases and then decreases.

As already described, the voltage actually causing the output Ic1 and Ic2 is Vb12 being the input Vbd less an error voltage Ve = Ibd˚Rb due to the current Ibd flowing through the base resistances Rb:

$$Vb12 + Vbd - Ve$$

In a differential comparator, the delay of interest is the zero delay from when the input voltage Vbd passes through zero to when the differential output signal passes through zero, which in this case is when the collector currents Ic1 and Ic2 are equal. With reference to the model FIG. 2 and the accompanying description of its operation, this occurs when the internal base voltage Vb12 is zero. Provided that the error voltage is small in comparison with Vbd so that Vbd is approximately equal to Vb12, the delay is approximately Ve/(dVbd/dt). From the expressions for Ibd and Ve, the delay is approximately Rb*Cn(Vbd). For slowly changing signals, where said error voltage is small and Vb12 is nearly equal to Vb, the delay is statically nonlinear function of the input voltage Vbd, and is closely approximated by Rb*Cn(Vbd). The zero delay is Rb*Cn(0), i.e., the product of the base resistance and the peak value of the nonlinear "capacitance" Cn. In a bank of identical comparators, as in a parallel analog to digital converter, each comparator introduces the same delay when the input signal voltage is equal to its reference voltage, i.e., when Vbd is zero, so that there is no nonlinear signal distortion due to this delay.

However, in high speed parallel converters the error voltage is usually a significant fraction of the signal, often greater than the desired error of the converter. Because of the nonlinear dependence of the differential base current on Vb12 as already described, the comparator delay is a function of the rate of change of Vbd. The dependence of comparator delay on the rate of change of the input and on the circuit parameters is impossible to calculate mathematically. Numerical results from nonlinear circuit simulators such as SPICE, as well as measurements on hardware, show that the delay decreases significantly with increasing slew rate of the input signal.

This means that for signals Vbd with a wide range of slew rates the delay is different depending on the slew rate when the signal voltage is equal to each comparator's reference voltage. In a bank of identical comparators with different reference voltages as in a parallel analog to digital converter, the individual comparators contribute different delays, so that the different voltage levels of the input signal experience different delays. The net result is nonlinear signal distortion, and can be modelled by applying a distorted version of the input signal to a bank of comparators all having the same constant delay.

If the differential base current were proportional only to the rate of change of Vb12, and independent of the value of Vb12, then the internal base admittance would be a constant capacitance, and the comparator delay would be constant, regardless of the rate of change of the input Vbd. It is an objective of this invention to present a comparator circuit in which the dependence of the differential base current on the differential base voltage Vb12 is substantially reduced.

An increase in emitter-degeneration resistance R1 and R2 of the differential comparator 16 of FIG. 2 increases the range of differential input voltage Vbd for which transistors Q1 and Q2 are in their active regions. The accompanying decrease in gain decreases the slopes of the collector currents Ic1 and Ic2 shown in FIG. 3. As the gain and the slopes of Ic1 and Ic2 decrease, the magnitudes of currents Ib1, Ib2, Ije1, and Ije2 change. It hap pens that when the values of matching emitter-generation resistors R1 and R2 are suitably adjusted, the variation in differential base current Ibd with a differential input voltage of constant slew rate, over a range of differential input voltage including the range for which transistors Q1 and Q2 are active, may be substantially reduced. Thus according to the present invention, the values of emitter-degeneration resistors R1 and R2 of the differential comparator of FIG. 2 are adjusted so as to substantially minimize variation in the differential input current Ibd over the range of differential input voltage Vbd for which transistors Q1 and Q2 are both active when Vbd changes with constant slew rate. Since the differential input current Ibd is substantially constant with respect to differential input voltage, the comparator exhibits minimal signal delay distortion due to Ibd flowing through the base resistances Rb1 and Rb2. Thus by suitably adjusting the values of R1 and R2, signal delay distortion in the comparator 16 of FIG. 2 may be minimized.

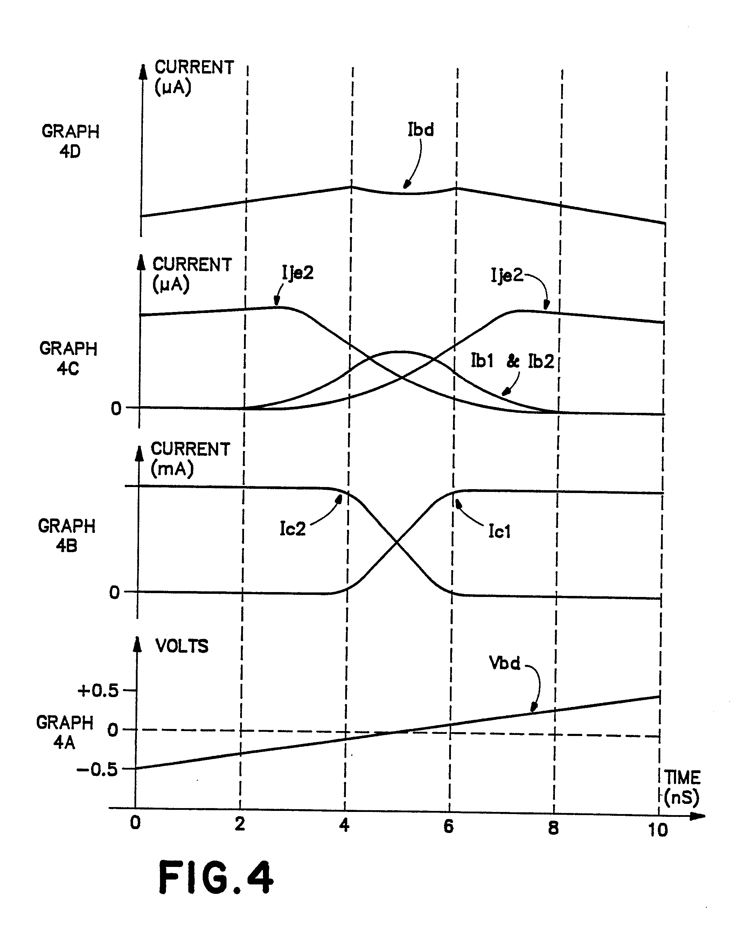

FIG. 4 is a set of graphs 4A-4D similar to the graphs 3A-3D of FIG. 3 but which graphs depict the operation of the differential comparator 16 of FIGS. 1 and 2 when the values of emitter-degeneration resistances R1 and R2 have been adjusted according to the present invention to minimize variation in differential input current Ibd with a differential input voltage Vbd of constant slew rate. When transistors Q1 and Q2 are active, by increasing the emitter-degeneration resistance, the slopes of collector currents Ic1 and Ic2, and therefore magnitudes of the base current components Ib1 and Ib2, are reduced over those shown in FIG. 3. Also the emitter-degeneration resistors reduce the junction capacitance currents Ije1 and Ije2 when transistors Q1 and Q2 are both conducting, as is well known from circuit theory. These changes cause a reduction in the peak of Ibd over that seen in FIG. 3. The values of R1 and R2 are increased to the point, as shown in FIG. 4, where Ibd is substantially constant for a range of input voltages Vbd including the range for which transistors Q1 and Q2 are active. Since the differential base current Ibd is substantially constant over this range, the input current Ibd is substantially constant with respect to the input voltage Vbd, and as long as Vbd remains within this range, signal delay distortion is minimal.

If the emitter-degeneration resistors R1 and R2 of FIG. 2 were further increased in magnitude, the magnitudes of all the base current components would decrease over the range for which transistors Q1 and Q2 are both active. As a result, the base current Ibd would not be substantially constant but would fall sharply and then rise as Vbd is increased within the range for which Q1 and Q2 are active. In such case the differential input capacitance Cbd would again be dependent on the slew rate of the differential input voltage Vbd and would cause input signal delay distortion. Thus the values of resistor R1 and R2 must be chosen to optimize the "flatness" of the Ibd graph of FIG. 4.

The appropriate choice of emitter-degeneration resistance depends on the characteristics of transistors Q1 and Q2 of the differential comparator. For a differential comparator implemented utilizing discrete components, the appropriate emitter-degeneration resistance may be determined experimentally by monitoring the behavior of the differential input current Ibd and collector currents Ic1 and Ic2 in response to a differential input voltage Vbd of a constant, relatively high slew rate as the emitter-degeneration resistance value is increased from zero. (The slew rate of Vdb should be high enough to ensure that Ibd is primarily a capacitance charging current.) The appropriate value of emitter-degeneration resistance is obtained when Ibd is substantially constant over a range of differential input voltage including the range for which Ic1 and Ic2 change in response to Vbd.

Of course this experimental method is not practical when the differential comparator is to be implemented in integrated circuit form since the integrated emitter-degeneration resistors are usually not readily adjustable and circuit parameters may not be accessible for measurement. Fortunately computer programs for modeling integrated circuits utilizing Gummel-Poon transistor models are widely available, and to ascertain the appropriate emitter-degeneration resistance to minimize delay distortion for an integrated circuit differential comparator, it is necessary only to utilize one such program to mode the differential comparator to perform a similar experiment utilizing the comparator model as would be performed utilizing an actual comparator circuit.

As seen in graph 4D of FIG. 4, when the adjustment of emitter-generation resistance is made according to the present invention, the differential base current is substantially constant over a range including the range for which the amplifier transistors operate in their active regions. Thus when differential comparator stages are connected in series such that the output of one stage drives the input of the next, delay distortion through the series of comparator stages is minimized when the output signal of each stage is limited to the input range of the next stage for which the differential base current is substantially constant. For example in the strobed comparator 10 of FIG. 1, to minimize delay distortion through differential comparators 16 and 28. the values of emitter-degeneration resistors R1. R2, R5 and R6 may be adjusted as described according to the present invention such that variation in the differential base current in each comparator is substantially constant over a range including the range for which the comparator transistors are active. Load resistors R3 and R4 are adjusted to limit the magnitude of the output voltage Va of comparator stage 12 to the range for which the differential input current of comparator 28 is substantially constant.

In differential comparator circuits of the prior art, emitter-degeneration resistors, when employed, are utilized to increase the range of differential input voltage for which the emitter-coupled transistors are both active so as to increase the range over which the differential collector current has a linear response to changes in input voltage. Since an increase in emitter-degeneration resistance causes a decrease in gain, the value of emitter-degeneration resistance was chosen to achieve an appropriate balance between gain and input voltage range, and not to provide for a constant input capacitance. In strobed comparators of the prior art utilizing emitter-coupled transistor pairs, linear response of comparator stages is not particularly beneficial and therefore emitter-degeneration resistors are not provided. The inclusion of emitter-degeneration resistors R1, R2, R5 and R6 in the comparators 16 and 28 of the strobed comparator 10 of FIG. 1, and the adjustment of the magnitude of these resistors according to the present invention, provides an improved strobed comparator circuit for which delay distortion is minimized.

While the preferred embodiment of the present invention has been shown and described, it will be apparent to those skilled in the art that many changes and modifications may be made without departing from the invention in its broader aspects. The appended claims are therefore intended to cover all such stages and modifications as follows in the true spirit and scope of the invention.

## Claims

1. A comparator responsive to an input voltage comprising:
two resistors; and
two transistors, each having a control terminal and carrying a load current of magnitude controlled by said input voltage applied across the control terminals of said two transistors, the load current of each transistor being transmitted through a separate one of said resistors, said resistors being sized so as to substantially minimize variation in capacitance between the control terminals of said two transistors with respect to input voltage.

2. A comparator responsive to an input voltage comprising:

two resistors; and

two transistors, each having a control terminal and carrying a load current of magnitude controlled by said input voltage applied across the control terminals of said two transistors, the load current of each transistor being transmitted through a separate one of said resistors, said resistors being sized so as to substantially minimize variation with respect to said input voltage of a current produced in the control terminals of said transistors when said input voltage changes with a constant slew rate.

3. A comparator responsive to an input voltage comprising:

a current source;

two resistors; and

two transistors each having a base, an emitter, and a collector, the emitter of each transistor being coupled to said current source through a separate one of said resistors, said resistors being sized so as to substantially minimize variation in current produced in the bases of said transistors with respect to said input voltage applied between the bases of said transistors when said input voltage changes with a constant slew rate over a predetermined magnitude range.

4. The comparator according to claim 3 wherein said predetermined magnitude range comprises input voltage magnitudes for which both transistors conduct current in their collectors.

5. A differential comparator comprising:

a voltage source;

a current source;

two resistors;

two transistors each having a base, an emitter coupled to said current source through a separate one of said emitter-degeneration resistors, and a collector coupled to said voltage source, said resistors being sized so as to substantially minimize variation in current produced in the bases of said transistors with respect to an input voltage applied between the bases of said transistors when said input voltage changes with a constant slew rate.

6. A latching comparator comprising:

a voltage source;

a current source;

two emitter-degeneration resistors;

two load resistors;

two transistors, each having an emitter, a base, and a collector, each collector being coupled to said voltage source through a separate one of said two load resistors such that when the emitter of each of said two transistors is coupled to said current source through a separate one of said emitter-degeneration resistors, an input voltage applied across the bases of said two transistors produces an output voltage between the collectors of said two transistors, said emitter-degeneration resistors being sized so as to substantially minimize variation in current produced in the bases of said transistors by said input voltage when said input voltage changes with a constant slew rate;

a feedback amplifier for producing an output signal of state determined according to the polarity of said output voltage between the collectors of said two transistors when said feedback amplifier is connected to said current source; and

means for selectively coupling said current source to the emitter of each of said two transistors through a separate one of said emitter-degeneration resistors and for alternatively connecting said current source to said feedback amplifier.

7. A method for minimizing delay distortion in a differential comparator of the type having two resistors and two transistors, each transistor having a control terminal and carrying a load current of magnitude controlled by an input voltage applied across the control terminals of said two transistors, the load current of each transistor being transmitted through a separate one of said resistors, the method comprising the step of selecting the resistances of said resistors so as to substantially minimize variation in capacitance between the control terminals of said two transistors with respect to input voltage.

8. A method for minimizing delay distortion in a differential comparator of the type having a current source, two resistors and two transistors, each transistor having a control terminal and carrying a load current of magnitude controlled by an input voltage applied across the control terminals of said two transistors, the load current of each transistor being transmitted through said current source and through a separate one of said resistors, the method comprising the step of selecting the resistances of said resistors so as to substantially minimize variation with respect to input voltage of a current produced in the control terminals of said transistors when said input voltage changes with a constant slew rate over a predetermined magnitude range.

FIG. I

FIG.2

FIG. 3

FIG.4